Europäisches Patentamt

European Patent Office

Office européen des brevets

(19)

(11) Veröffentlichungsnummer: **0 093 818**
A1

# (12) EUROPÄISCHE PATENTANMELDUNG

(21) Anmeldenummer: 82710027.2

(22) Anmeldetag: 07.05.82

(51) Int. Cl.³: **H 01 L 27/02**, H 01 L 29/94, G 05 F 3/20

(43) Veröffentlichungstag der Anmeldung: **16.11.83**
**Patentblatt 83/46**

(84) Benannte Vertragsstaaten: **DE FR GB IT NL**

(71) Anmelder: **Deutsche ITT Industries GmbH,
Hans-Bunte-Strasse 19 Postfach 840, D-7800 Freiburg
(DE)**

(84) Benannte Vertragsstaaten: **DE**

(71) Anmelder: **ITT INDUSTRIES INC., 320 Park Avenue, New
York, NY 10022 (US)**

(84) Benannte Vertragsstaaten: **FR GB IT NL**

(72) Erfinder: **Micic, Ljubomir, Dipl.-Ing., Sundgauallee 15,
D-7800 Freiburg (DE)**
Erfinder: **Mlynek, Daniel, Dr., 7, Rue des Jardins,
F-68600 Wolfgantzen (FR)**
Erfinder: **Backes, Reiner, Dipl.-Ing., Am Märzengraben 2,
D-7800 Freiburg (DE)**
Erfinder: **Schmidtpott, Friedrich, Ing. grad.,
Gewerbestrasse 13, D-7803 Gundelfingen (DE)**

(74) Vertreter: **Stutzer, Gerhard, Dr., Deutsche ITT Industries
GmbH Patent- und Lizenzabteilung
Hans-Bunte-Strasse 19 Postfach 840, D-7800 Freiburg
(DE)**

(54) Monolithisch integrierte Schaltung mit integrierten Kondensatoren.

(57) Die integrierten Kondensatoren sind in den üblicherweise freibleibenden, zwischen den Anschlußpads (2...) untereinander und zwischen diesen sowie benachbarten Schaltungsteilen (3) und dem Rand des Substrats (1) der integrierten Schaltung liegenden Teilen der Oberfläche so angeordnet, daß sie mindestens einen Anschlußpad (2...) mindestens teilweise umgreifen. Bei einer MOS-integrierten Schaltung mit Substratvorspannungsgenerator-Schaltung (17) liegt einer der Kondensatoren zwischen den Leitungen (14, 15) für die Betriebsspannung und den Schaltungsnullpunkt und einer zwischen den Leitungen (16, 15) für den Substratanschluß und den Schaltungsnullpunkt.

Fl 1141 EP                    L. Micic et al 22-9-8-5
                              Mo/bk
                              04. Mai 1982

## Monolithisch integrierte Schaltung mit integrierten Kondensatoren

Die Erfindung betrifft eine monolithisch integrierte Schaltung mit integrierten Kondensatoren und mit einem Halbleiterkörper als Substrat, bei dem die Schaltungsteile an und in einer Oberflächenseite des Substrats angeordnet sind, an deren Rand voneinander beabstandete Anschlußpads liegen, vgl. den Oberbegriff des Anspruchs 1.

Bekanntlich bereitet die Integrierung von Kondensatoren mit Kapazitätswerten von größer als etwa 10 bis 50 pF insofern Schwierigkeiten, als der Flächenbedarf unverhältnismäßig groß ist, vgl. z.B. die Zeitschrift "Scientia Electrica", 1963, Seiten 82 und 83..

Die Aufgabe der in den Ansprüchen gekennzeichneten Erfindung besteht daher darin aufzuzeigen, wie trotz beschränkter vorgegebener Fläche einer monolithisch integrierten Schaltung Kondensatoren mit einem Flächenbedarf, der bei üblichem Layout die vorgegebene Kristallfläche überschreiten würde, realisiert werden können. Unter üblichem Layout ist dabei zu verstehen, daß die Anschlußpads innerhalb eines am Rande der einen Oberflächenseite des Halbleiterkörpers angeordneten Streifens liegen und daß die Schaltungsteile und deren Verbindungsleitungen untereinander und mit den Pads im wesentlichen in dem von dem erwähnten Streifen umschlossenen restlichen Gebiet der Halbleiteroberfläche angeordnet sind.

Fl 1141 EP                    L.Micic et al 22-9-8-5

Die Erfindung wird nun anhand der Figuren der Zeichnung näher erläutert.

Fig. 1    zeigt schematisch einen Eck-Ausschnitt aus dem Grundriß einer monolithisch integrierten Schaltung mit erfindungsgemäßer Anordnung von integrierten Kondensatoren,

Fig. 2    zeigt als Ausführungsbeispiel den bevorzugten Aufbau der bei der Erfindung verwendeten Kondensatoren und

Fig. 3    zeigt als weiteres Ausführungsbeispiel ebenfalls einen Eckausschnitt aus dem Grundriß einer monolithisch integrierten Schaltung mit Kondensatoren, die mit weiteren Schaltungsteilen verbunden sind.

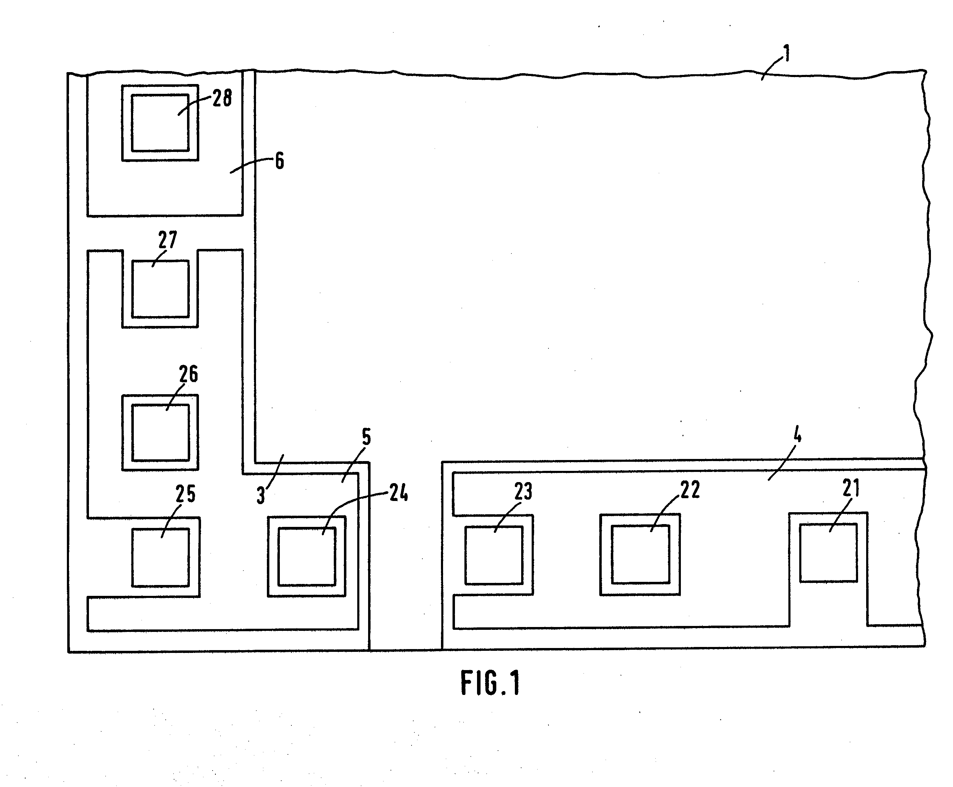

In Fig. 1 ist schematisch im Grundriß die eine Ecke einer monolithisch integrierten Schaltung nach der Erfindung gezeigt. Dabei sind auf dem Substrat 1 an deren Rand die Anschlußpads 21, 22, 23, 24, 25, 26, 27, 28 streifenartig angebracht, wobei deren Abstand untereinander unterschiedlich sein kann, wie es die Fig. 1 zeigt; dieser Abstand ist jedenfalls durch das spezielle Schaltungs-Layout bedingt. Die Schaltungsteile 3 der integrierten Schaltung sind in Fig. 1 nicht näher veranschaulicht, da sie beliebiger Art sein können; es ist jedoch zeichnerisch veranschaulicht, daß diese Schaltungsteile 3 im wesentlichen innerhalb des von den Anschlußpads 21... gebildeten Randstreifens üblicherweise angeordnet sind, wobei jedoch durch den zwischen den Anschlußpads 23, 24 vorhandenen und bis zum Rand des Substrats 1 reichenden Streifen angedeutet ist, daß auch zwischen den Anschlußpads ggf. Schaltungsteile angeordnet sein können.

Entsprechend der Erfindung sind nun in denjenigen Bereichen der Oberfläche, die zwischen den Anschlußpads untereinander und zwischen diesen sowie benachbarten Schaltungsteilen 3

und dem Rand des Substrats 1 liegen,

Kondensatoren 4, 5, 6 angeordnet sind, die mindestens einen Anschlußpad mindestens teilweise umgreifen. So sind beispielsweise die Anschlußpads 22; 24, 26; 28 von dem jeweiligen Kondensator 4; 5; 6 vollständig umschlossen, während die Anschlußpads 21, 23; 25, 27 nur teilweise umgriffen sind. Diese jeweilige spezielle Layout-Gestaltung hängt ganz von den konkreten Bedürfnissen der zu entwerfenden integrierten Schaltungen ab. Abschließend zur Erläuterung von Fig. 1 sei hervorgehoben, daß darin die Kondensatoren 4, 5, 6 der Einfachheit halber nur mit deren maximal möglicher Fläche gezeichnet sind, ohne auf deren Kontaktierungszonen und Anschlüsse Rücksicht zu nehmen. Die von den Kondensatoren eingenommene Fläche weist somit, wie die Fig. 1 zeigt, zu den benachbarten Schaltungsteilen 3 und den jeweils benachbarten oder umschlossenen Anschlußpads jeweils den üblichen Sicherheitsabstand auf.

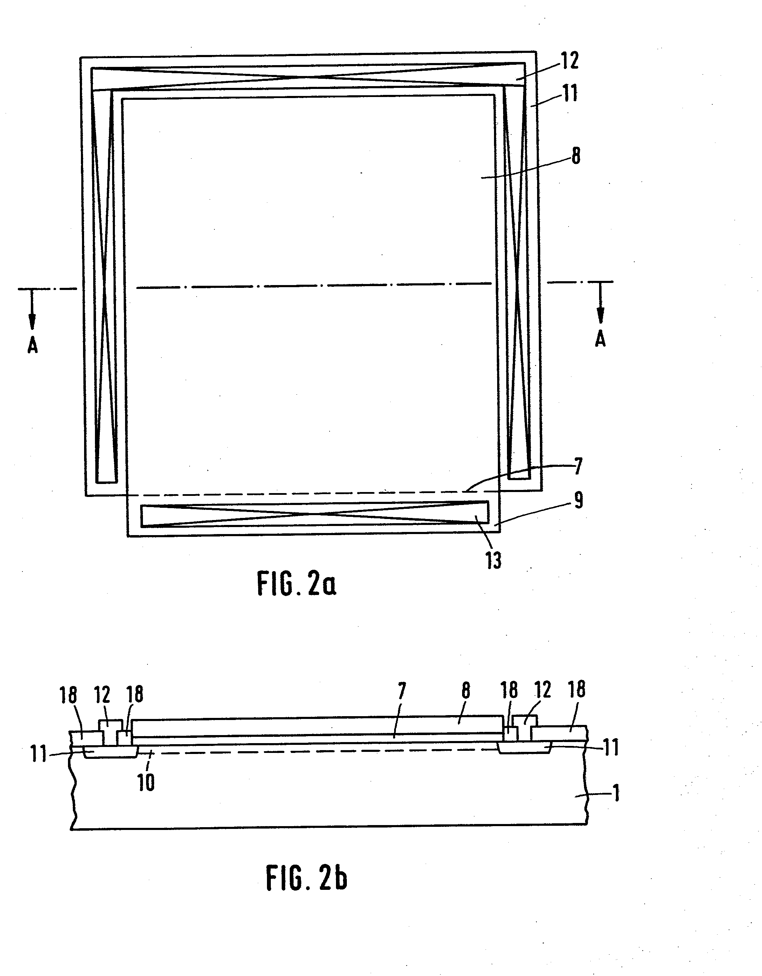

Die Fig. 2 zeigt schematisch den Aufbau eines bevorzugten Ausführungsbeispiels für einen Kondensator, und zwar den Aufbau eines Kondensators für eine in Isolierschicht-Feldeffekttransistor-Technik, also in MOS-Technik, realisierte integrierte Schaltung. In Fig. 2 ist somit der bevorzugte Aufbau eines MOS-Kondensators gezeigt, wobei die Fig. 2a dessen Grundriß und die Fig. 2b den Schnitt entlang der Linie A-A nach Fig. 2a zeigt. Der erste Belag des MOS-Kondensators besteht dabei aus der Halbleiterzone 10 (Fig.2b), die unter der zusammen mit der Gate-Isolierschicht der Feldeffekttransistoren gebildeten ("Gate")-Isolierschicht 7 gleicher Dicke angeordnet ist. Als Dielektrikum des MOS-Kondensators dient somit eine Isolierschicht, die der Gate-Isolierschicht von Feldeffekttransistoren hinsichtlich ihres Materials und ihrer Dicke entspricht. Die Halbleiterschicht 10 geht außerhalb des Randes der Isolierschicht 7 in die ihn

L. Micic et al 22-9-8-5                                    Fl 1141 EP

teilweise umgreifende Randzone 11 gleichen Leitungstyps
über. Diese Randzone 11 wird zusammen mit den Source- und
Drain-Zonen der Feldeffekttransistoren hergestellt und
entspricht diesen somit hinsichtlich von Leitungstyp, Eindringtiefe und spezifischem Widerstand.

Die Halbleiterzone 10 erhält entweder schon bei der Herstellung den zum Substratleitungstyp entgegengesetzten
Leitungstyp, oder dieser zum Substratleitungstyp entgegengesetzte  Leitungstyp der Halbleiterzone 10 wird erst
während des Betriebs der integrierten Schaltung hervorgerufen. Im ersteren Fall handelt es sich beim Kondensator
nach Fig. 2 um einen mit einem Depletion-Transistor vergleichbaren Kondensatortyp, also um einen "Depletion"-
Kondensator, während im letzteren Fall es sich um einen
"Enhancement"-Kondensator handelt.

Der zweite Belag des Kondensators nach Fig. 2 besteht aus
der auf der Isolierschicht 7 angeordneten Leitschicht 8,
die an einer Stelle den die Isolierschicht 7 nicht überdeckenden Fortsatz 9 aufweist, vgl. die Fig. 2a, in der
der beim Fortsatz 9 liegende Rand der Isolierschicht 7
durch die gestrichelte Linie angedeutet ist. Durch diesen
Fortsatz 9 wird erreicht, daß die elektrische Kontaktierung
des zweiten Belags, also der Leitschicht 8, nicht über der
Isolierschicht 7 vorgenommen werden muß, was,insbesondere
bei der einen Ausführungsvariante mit polykristallinem
Silicium als Leitschicht 8,zu Unzuträglichkeiten führen
würde, da das im allgemeinen verwendete Kontaktmetall
Aluminium das polykristalline Silicium bis zur Isolierschicht 7 durchdringen könnte,und somit beim "Enhancement"-
Kondensator die Schwellspannungsverhältnisse instabil machen
würde. Die Kontaktierung der Leitschicht 8 erfolgt daher
im Bereich des Fortsatzes 9, was in Fig. 2a durch den

L. Micic et al 22-9-8-5                    Fl 1141 EP

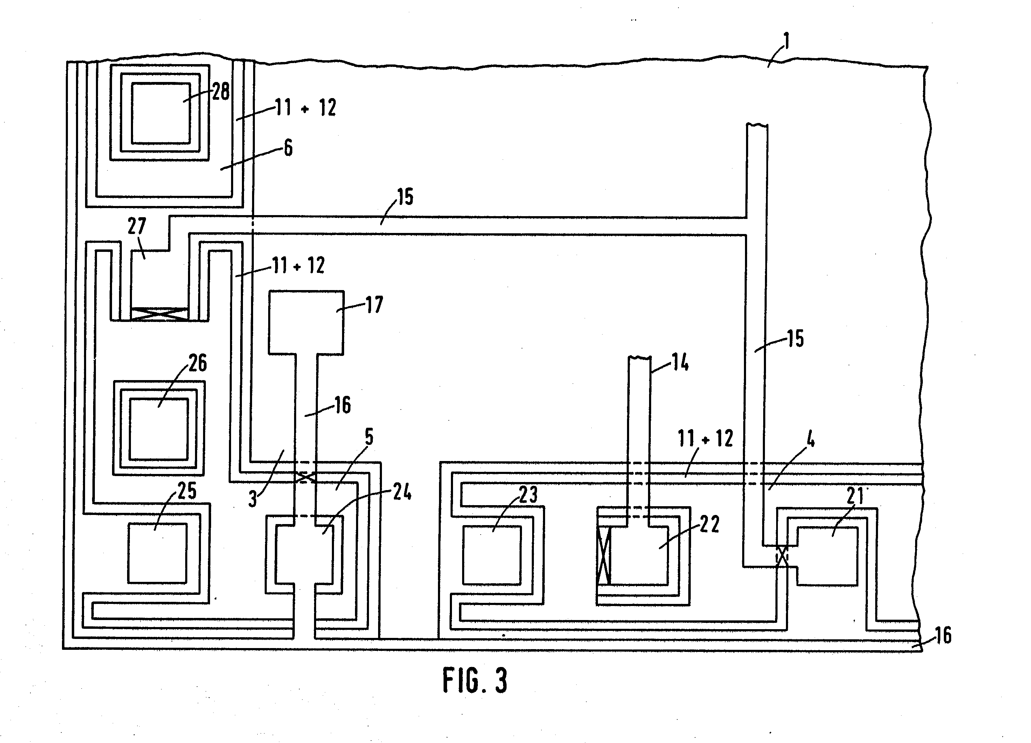

Aluminiumkontakt 13 angedeutet ist. Ebenso ist die Randzone 11 mit einer Aluminiumschicht 12 kontaktiert. In Fig. 2a
und ebenso in der noch näher zu erläuternden Fig. 3 sind
derartige Kontaktierungszonen durch Durchkreuzung markiert.
Aus dem Querschnitt der Fig. 2b ist schließlich noch zu
entnehmen, daß das Substrat 1 außerhalb von Isolierschicht 7
und Leitschicht 8 mit einer dickeren Isolierschicht 18
bedeckt ist, durch die hindurch die Kontaktierung der Randzone 11 erfolgt.

Die Fig. 3 zeigt für die bevorzugte Verwendung der entsprechend der Erfindung angeordneten Kondensatoren 4,5,6
einen entsprechenden Grundriß. Diese bevorzugte Verwendung
ergibt sich bei einer in Isolierschicht-Feldeffekttransistor-
Technik integrierten Schaltung mit einer Substratvorspannungsgeneratorschaltung 17. Derartige Generatorschaltungen sind an sich bekannt, vgl. rein beispielsweise die
Offenlegungsschrift DE 30 30 654 A1, insbesondere Fig. 1.
Sie besteht aus einer mitintegrierten Schwingungs- oder
Oszillatorschaltung und einer Gleichrichterschaltung, die
als Glättungskondensatoren     parasitäre Kapazitäten der
integrierten Schaltung verwendet.

Bei der Anordnung nach Fig. 3 ist die eine dieser parasitären Kapazitäten, nämlich die zwischen dem Substratanschluß und dem Anschluß für den Schaltungsnullpunkt, durch
den einen der Kondensatoren, nämlich den Kondensator 5,
wesentlich vergrößert, so daß die Glättungs- und Pufferwirkung auf den Gleichrichtteil der Substratvorspannungsgeneratorschaltung 17 wesentlich verbessert ist. Der Kondensator 5 ist daher einerseits mit der am Substrat liegenden
Leitung 16, die im allgemeinen am Rand des Substrats 1 verläuft, und mit der am Schaltungsnullpunkt liegenden Leitung 15 verbunden, die auch mit den Anschlußpads 21, 27

L. Micic et al 22-9-8-5                                    Fl 1141 EP

in Verbindung steht. Bei der Kontaktierung der Kondensatoren
ist natürlich auf die richtige Polarität zu achten. In
Fig. 3 ist daher vorausgesetzt, daß es sich um eine n-Kanal-
Schaltung handelt, so daß die Betriebsspannung positiv
und die Substratvorspannung negativ ist. Beim Kondensator 5
ist daher die Leitschicht 8 über den Fortsatz 9 und dessen
Kontakt 13 mit der positiven Spannung, also mit der Leitung 15 des Schaltungsnullpunkts, verbunden und die Halbleiterzone 10 über die Randzone 11 und deren Kontakt 12
mit der Leitung 16 zur Generatorschaltung 17.

Der Kondensator 4 liegt zwischen der Leitung 14 für die
Betriebsspannung und der Leitung 15 des Schaltungsnullpunkts.Der Kondensator 4 hat somit an der Verbindungsstelle
mit der Leitung 14 einen Kontakt entsprechend 9 von Fig. 2a
und an der Verbindungsstelle mit der Leitung 15 einen Kontakt entsprechend 12 nach Fig. 2a. Durch den Kondensator 4
ergibt sich somit eine Verbesserung des Frequenzverhaltens
der integrierten Schaltung bezüglich der Betriebsspannung.

0093818

L. Micic et al 22-9-8-5

Fl 1141 EP
Mo/bk
04. Mai 1982

Patentansprüche

1. Monolithisch integrierte Schaltung mit integrierten Kondensatoren (4, 5, 6) und mit einem Halbleiterkörper als Substrat (1), bei dem die Schaltungsteile (3) an und in einer Oberflächenseite des Substrats (1) angeordnet sind, an deren Rand voneinander beabstandete Anschlußpads (21...28) liegen, dadurch gekennzeichnet, daß mindestens einer der integrierten Kondensatoren (4, 5, 6) in den üblicherweise freibleibenden, zwischen Anschlußpads (2...) untereinander und zwischen diesen sowie benachbarten Schaltungsteilen (3) und dem Rand des Substrats (1) liegenden Teilen der Oberfläche, mindestens einen Anschlußpad (2...) mindestens teilweise umgreifend, angeordnet sind.

2. In Isolierschicht-Feldeffekttransistor-Technik (MOS-Technik) integrierte Schaltung nach Anspruch 1, dadurch gekennzeichnet, daß die Kondensatoren (4, 5, 6) so ausgebildet sind, daß deren erster Belag aus einer Halbleiterzone (10) besteht, die unter einer zusammen mit der Gate-Isolierschicht der Feldeffekttransistoren gebildeten ("Gate")-Isolierschicht (7) gleicher Dicke angeordnet ist und die außerhalb des Randes der Isolierschicht (7) in eine ihn teilweise umgreifende Randzone (11) gleichen Leitungstyps übergeht, und daß deren zweiter Belag aus einer auf der Isolierschicht (7) angeordneten Leitschicht (8) besteht, die an einer Stelle einen die Isolierschicht (7) nicht überdeckenden Fortsatz (9) hat.

0093818

L. Micic et al 22-9-8-5          Fl 1141 EP

3. Integrierte Schaltung nach Anspruch 2, dadurch gekennzeichnet, daß die Halbleiterzone (10) und die Randzone (11) bereits bei der Herstellung einen zum Substratleitungstyp entgegengesetzten Leitungstyp erhalten haben ("Depletion" -Kondensator).

4. Integrierte Schaltung nach Anspruch 2, dadurch gekennzeichnet, daß nur die Randzone (11) bereits bei der Herstellung einen zum Substratleitungstyp entgegengesetzten Leitungstyp erhalten hat, dagegen die Halbleiterzone (10) während des Betriebs der integrierten Schaltung den entgegengesetzten Leitungstyp aufweist ("Enhancement" - Kondensator).

5. Integrierte Schaltung nach einem der Ansprüche 2 bis 4, dadurch gekennzeichnet, daß die Leitschicht (8) mit dem Fortsatz (9) aus polykristallinem Silicium besteht.

6. Integrierte Schaltung nach Anspruch 5, dadurch gekennzeichnet, daß der Fortsatz (9) mindestens teilweise mit einem Aluminiumkontakt (13) bedeckt ist.

7. Integrierte Schaltung nach einem der Ansprüche 2 bis 4, dadurch gekennzeichnet, daß die Leitschicht (8) mit dem Fortsatz (9) aus Aluminium besteht.

8. Integrierte Schaltung nach einem der Ansprüche 2 bis 7, dadurch gekennzeichnet, daß die Randzone (11) mindestens teilweise mit einer Aluminiumschicht (12) kontaktiert ist.

9. Integrierte Schaltung nach einem der Ansprüche 2 bis 8 mit einer Substratvorspannungsgenerator-Schaltung (17), dadurch gekennzeichnet, daß mit einer an Betriebs-

0093818

spannung und mit einer am Schaltungsnullpunkt liegenden Leitung (14, 15) ein erster zwischen Anschlußpads (21, 22, 23) angeordneter Kondensator (4) sowie mit einer am Substrat (1) und mit einer am Schaltungsnullpunkt liegenden Leitung ( 16, 15)ein zweiter zwischen anderen Anschlußpads (24, 25, 26) angeordneter Kondensator (5) verbunden ist.

82 7 1 0 0 2 7 2  0093818

FIG.1

82 71 0027·2
0093818

FIG. 2a

FIG. 2b

0093818

82 7 1 0 0 27 · 2

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-3 460 050  (M.J. HELLSTROM)<br>* Figuren 1,2; Spalte 2, Zeile 18 - Spalte 3, Zeile 34 * | 1-3,7 | H 01 L  27/02<br>H 01 L  29/94<br>G 05 F   3/20 |
| A | US-A-3 689 803  (T.H. BAKER et al.)<br>* Figuren 2,3; Spalte 4, Zeile 35 - Spalte 6, Zeile 9 * | 1 | |
| A | PATENTS ABSTRACTS OF JAPAN, Band 3, Nr. 25(E-94), 28. Februar 1979, Tokyo, JP.<br>& JP - A - 54 2683 (SUWA SEIKOSHA K.K.) 01.10.1979* Zusammenfassung * | 1 | |
| A | FR-A-2 249 446  (MOTORALA INC.)<br>* Figuren 1-5; Ansprüche * | 2,4,5 | RECHERCHIERTE SACHGEBIETE (Int. Cl. ³) |
| A | EP-A-0 048 474  (TOKYO SHIBAURA DENKI K.K.)<br>*  Figuren  2,3,4; Seite 1, Zeile 20 - Seite 9 * | 2,3,5, 9 | H 01 L |

Der vorliegende Recherchenbericht wurde für alle Patentansprüche erstellt.

| Recherchenort<br>DEN HAAG | Abschlußdatum der Recherche<br>06-01-1983 | Prüfer<br>CARDON A. |
|---|---|---|